# EUROPEAN PATENT APPLICATION

(11) **EP 4 579 341 A2**
(43) Date of publication of application: **02.07.2025**
(21) Application number: 25170404.5
(22) Date of filing: 14.04.2025
(51) Int. Cl.: G03F 7/00

(54) **SUBSTRATE DEVICE**

(71) Applicant: ASML Netherlands B.V., 5500 AH Veldhoven (NL)
(72) Inventor: RAJAKUMAR, Manjeeth, 5500 AH Veldhoven (NL); DEWANJI, Dipanjay, 5500 AH Veldhoven (NL); HUANG, Zhuangxiong, 5500 AH Veldhoven (NL); VAN DE KERKHOF, Marcus, Adrianus, 5500 AH Veldhoven (NL)
(74) Representative: ASML Netherlands B.V.

(57) **Abstract**

A substrate device for being held by an electrostatic substrate clamp, the substrate device having a bottom side with a bottom surface and a top side with a top surface, the bottom side being configured to face a substrate support surface of the substrate clamp in use, wherein the substrate device comprises one or more nozzle holes, the one or more nozzle holes extending from the bottom surface to the top surface.

## Description

### FIELD

The present invention relates to a substrate device for being held by an electrostatic substrate clamp and to a combination of the substrate device and the electrostatic substrate clamp. The present invention further relates to a lithographic apparatus comprising the combination. The present invention yet further relates to a method for cleaning a contaminated surface of a stage compartment of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

During the lithographic process the substrate, or wafer, is supported and clamped on a substrate support surface of an electrostatic substrate clamp. Over time surfaces above the electrostatic substrate clamp may become contaminated with e.g. particles. The required cleanliness level in for example a wafer stage compartment is extremely high since any contamination, e.g particle contamination, could affect the exposure process.

One way of maintaining the required cleanliness level of a stage compartment, e.g. a wafer stage compartment, is opening the compartment and manually cleaning the components and/or surfaces. This manual labor in itself is time-consuming. In addition, it requires the machine to be in atmospheric conditions, contrary to the typical vacuum or near-vacuum operating conditions of the stage compartment. Returning to the operational vacuum or near-vacuum conditions also requires substantial time.

### SUMMARY

It is an object of the invention to provide an improved device or method for cleaning a stage compartment of a lithographic apparatus.

According to an aspect of the invention, there is provided a substrate device for being held by an electrostatic substrate clamp, the substrate device having a bottom side with a bottom surface and a top side with a top surface, the bottom side being configured to face a substrate support surface of the substrate clamp in use, wherein the substrate device comprises one or more nozzle holes, the one or more nozzle holes extending from the bottom surface to the top surface.

According to another aspect of the invention, there is provided a combination of an electrostatic substrate clamp and a substrate device, the substrate device being configured to be supported on the electrostatic substrate clamp during use.

According to still another aspect of the invention, there is provided a lithographic apparatus comprising a combination of an electrostatic substrate clamp and a substrate device.

According to yet another aspect of the invention, there is provided a method for cleaning a contaminated surface of a stage compartment of a lithographic apparatus, the method comprising:
a) providing and clamping a substrate device onto a substrate support surface of an electrostatic substrate clamp arranged in the stage compartment,
b) providing a gas through the one or more nozzle holes to generate one or more gas streams or one or more gas jets flowing in an upward direction from the bottom side to the top side,
c) directing the gas stream or gas jet to the contaminated surface in order to detach particles adhering to the contaminated surface.

### BRIEF DESCRIPTION OF THE DRAWINGS

Embodiments of the invention will now be described, by way of example only, with reference to the accompanying schematic drawings in which like reference symbols designate like parts, in which.
- Figure 1 depicts a lithographic system comprising a lithographic apparatus and a radiation source;
- Figure 2 schematically depicts in cross-section a stage compartment of a lithographic apparatus comprising an embodiment of a substrate device according to the invention, and an embodiment of a combination according to the invention.
- Figure 3 schematically depicts a perspective top view of an embodiment of a substrate device according to the invention comprising one nozzle hole.
- Figure 4 schematically depicts a perspective top view of an embodiment of a substrate device according to the invention comprising four nozzle holes.
- Figure 5 schematically depicts a top view of an embodiment of a substrate device according to the invention supported on an electrostatic substrate clamp.
- Figure 6 schematically depicts a detail A of figure 2 for an embodiment of the substrate device.
- Figure 7 schematically depicts a detail A of figure 2 for another embodiment of the substrate device.

### DETAILED DESCRIPTION

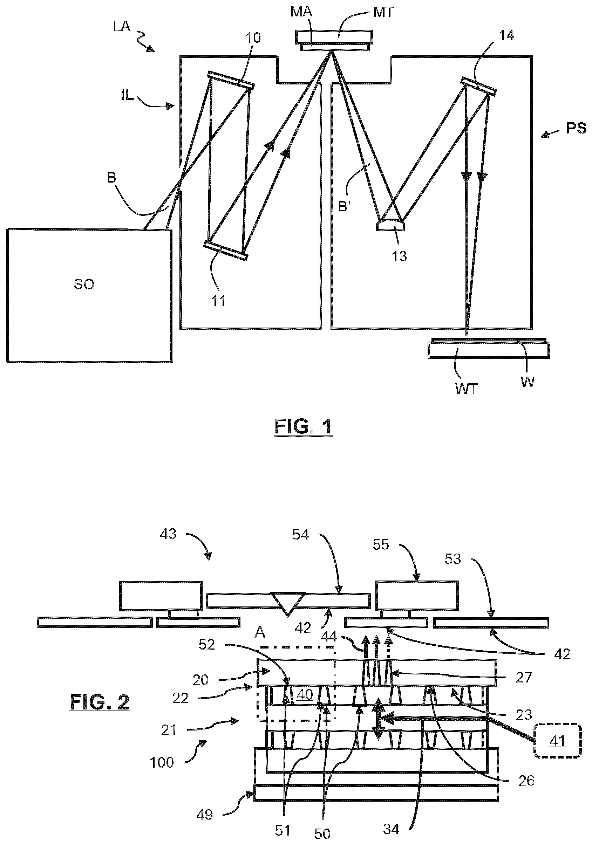

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Turning to figure 2, an embodiment is shown of a combination 100 of an electrostatic substrate clamp 21 and an embodiment of a substrate device 20 that is being supported, and held, or clamped, by the electrostatic substrate clamp 21. The substrate device 20 has a bottom side 22 that faces a substrate support surface 26 of the substrate clamp 21. The combination 100 is part of a system further comprising a power source 49 configured to power the substrate device 20 by providing electrical power to one or more clamp conductors 50 of the electrostatic substrate clamp 21. The electrostatic substrate clamp 21 is part of the earlier mentioned substrate table WT. The substrate device 20 may be used on the same electrostatic substrate clamp 21 as to be manufactured substrates. It may also be possible to provide a separate electrostatic substrate clamp 21 that is dedicated only for the substrate device 20.

The electrostatic substrate clamp 21 has a plurality of burls 51, e.g. located on an upper surface of the substrate clamp 21, for supporting a substrate during use, here the substrate device 20. The plurality of substrate clamp burls 51 form the substrate support surface 26 with respective top surfaces 52 thereof. Substrate clamp burls 51 are interconnected via conductive lines that may be referred to as 'Manhattan lines' (not shown) and which may be electrically connected to a power source at least for the purpose of the present disclosure.

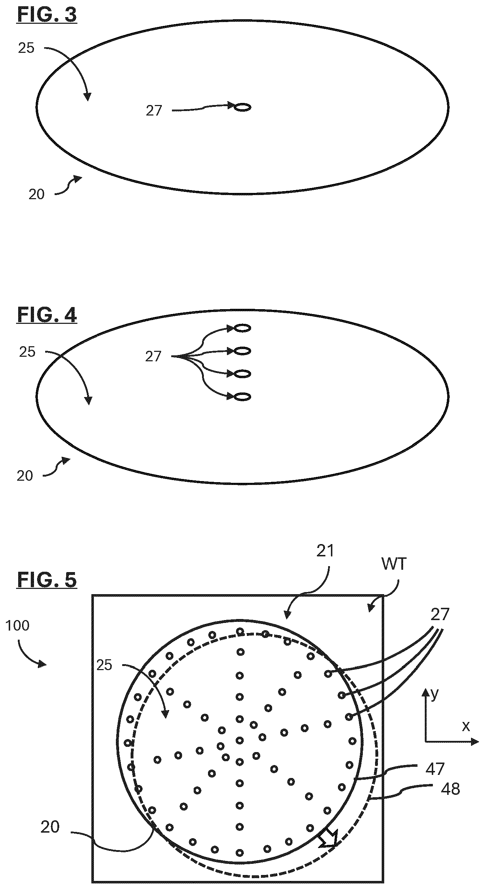

The substrate device 20, as exemplary shown in figures 2 to 6, has a bottom side 22 with a bottom surface 23 and a top side 24 with a top surface 25. The bottom side 22 faces a substrate support surface 26 of the substrate clamp 21 in use. The substrate device 20 comprises one or more nozzle holes 27. The one or more nozzle holes 27 extend from the bottom surface 23 to the top surface 25. Figure 3 shows an example, wherein the substrate device 20 has one nozzle hole. Figure 4 shows an example, wherein the substrate device 20 has four nozzle holes 27. Figure 5 shows an example, wherein the substrate device 20 has tens of nozzle holes 27.

A space 40 is located between the substrate clamp burls 51 and below the substrate device 20 when supported on the substrate support surface 26. During use the one or more nozzle holes 27 are in fluid communication with the space 40 and the space 40 is in fluid communication with a gas supply 41. The gas travels through the one or more nozzle holes 27 and exits as a gas stream or gas jet 44 travelling towards a contaminated surface 42 located above the substrate device 20. Particles on the contaminated surface 42 are dislodged by the gas stream or gas jet 44, thereby cleaning the contaminated surface 42.

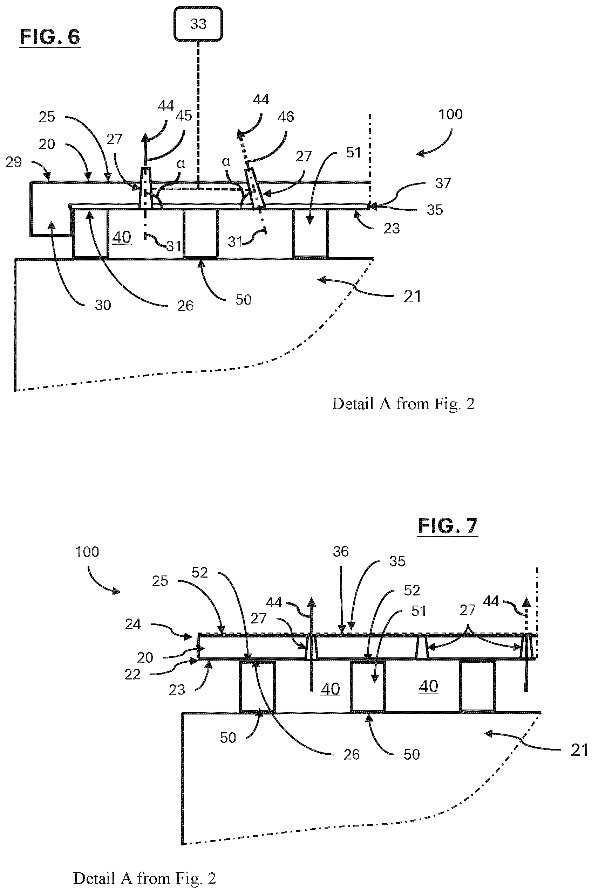

Turning to figure 6(A), the substrate device 20 is plate 29 shaped, or is a plate 29. The plate 29 may have a thickness, e.g. 0.5 mm or more. In an embodiment, the thickness may be between 0.5 mm and 50 mm, preferably between 0.7 mm and 20 mm, more preferably between 0.7 mm and 15 mm. The thickness may e.g. correspond to the thickness of a standard semiconductor wafer. An upper limit of the thickness may be governed by limitations imposed by the transport system which is used to bring the substrate device 20 into the lithographic apparatus and onto the substrate support. An edge 28 of the plate 29 may at least partially be provided with a rim 30 projecting away from the bottom side 22. In particular the edge 28 of the plate 29 is fully provided with the rim 30. The rim 30 is configured to extend around, or enclose the burls 51, as for example shown in the detail of figure 6(A). This may reduce gas leakage at the edge 28 of the substrate device 20, and may result in a higher pressure of one or more gas streams or one or more gas jets 44.

One or more nozzle holes 27 may extend above the top surface 25. This way the exit location of the gas stream or gas jet may be closer to a contaminated surface 42 above the substrate device 20, while limiting the overall thickness of the substrate device 20. Providing the exit location closer to the contaminated target surface may reduce jet dissipation in vacuum, or near vacuum, and may allow higher-speed flow at the areas requiring cleaning.

The one or more nozzle holes 27 have a central nozzle axis 31. The central nozzle axis 31 extends under an angle α with respect to the bottom surface 23 and/or with respect to the top surface 25. The angle α may be 90 degrees, as shown for the left nozzle hole 27 in figure 6(A) and the nozzle holes 27 in figure 7(A). The angle α may instead lie between 0 and 90 degrees, as for example shown for the right nozzle hole 27 in figure 6(A). With an angle α between 0 and 90 degrees the gas stream or gas jet exiting the nozzle hole 27 will have a higher shear force component on the contaminated surface 42 that is targeted when the contaminated surface 42 extends for example parallel to the substrate device 20. A higher shear force component may improve the likelihood of removing a particle from the contaminated surface 42 with the gas stream or gas jet. A substrate device 20 may be provided with a plurality of nozzle holes 27 with a plurality of angles α.

Figures 6(A) and 7(A) show examples of the substrate device 20 comprising a detached particle collection device 35. These examples may be used solely, in combination 100, and/or together with a vacuum pump that is part of or connected to the stage compartment.

Figure 6(A) shows an example, wherein the detached particle collection device 35 comprises an insulating layer 37 provided on the bottom surface 23. By introducing, or applying an electrostatic charge gradient to the substrate device 20, e.g. by creating a small imbalance between the clamp conductors 50, in combination 100 with the insulating backside, particles detached from the contaminated surface 42 may adhere to the top surface 25 of the substrate device 20. In such arrangement, top surface 25 can either comprise an insulation layer or a conductive layer. In an embodiment, the top surface 25 comprises an insulation layer. In such embodiment, neutral particles may be attracted to the top surface by means of an induced mirror charge force and held at the surface.

Figure 7(a) shows an example, wherein the detached particle collection device 35 comprises an adhesive coating 36, e.g. comprising polyurethane, provided on the top surface 25. Particles that are dislodged, or detached from the contaminated surface 42 may fall on the top surface 25 of the substrate device 20, and thereby adhere to the adhesive coating 36.

One or more nozzle holes 27 may be configured to be in communication with a control device 33 for controlling a gas flow 34 through the one or more nozzle holes 27. The nozzle holes 27 may for example be provided as active micronozzles, e.g. including microvalves, such that gas can be controllably delivered in pulses, or intermitted, rather than in a continuous, or unintermitted flow. Instead, or in addition selectable or programmable nozzles can be incorporated so that flow is directed only to regions needing cleaning at any given time, thus minimizing unwanted gas usage or disturbance of other surfaces.

### Operation

In operation a contaminated surface 42 of a stage compartment of a lithographic apparatus, e.g. a wafer stage compartment, may be cleaned by first providing and clamping a substrate device 20, e.g. as shown in figures 2 to 6, onto a substrate support surface 26 of an electrostatic substrate clamp 21 arranged in the stage compartment. The substrate device 20 may be provided on the substrate support surface 26 in a similar or same way as a to be manufactured substrate. The contaminated surface 42 may for example be part of a heat shield 53, or screw holes of a dynamic gas lock 54. Figure 2 schematically shows the heat shield 53 and dynamic gas lock 54 associated with a wafer stage main frame 55. The contaminated surface 42 faces the electrostatic substrate clamp 21.

Subsequently gas is provided through the one or more nozzle holes 27 to generate one or more gas streams or one or more gas jets 44 flowing in an upward direction from the bottom side 22 to the top side 24.

The gas may be hydrogen. As hydrogen is often already used in a stage compartment, e.g. as backfill gas, few to no modifications are required.

The gas may instead be nitrogen or extreme clean dry air. Such gases are heavier than hydrogen, and may improve particle removal.

The gas stream or gas jet are directed to the contaminated surface 42 in order to detach particles adhering to the contaminated surface 42.

Detached particles may be collected by a vacuum pump and/or by a detached particle collecting device of the substrate device 20.

The cleaning may be performed under vacuum conditions or under near vacuum conditions. This way the stage compartment, e.g. the scanner, does not need to go through a time-costly pump-vent-pump sequence. Hence, availability, or workability, of the stage compartment may be improved by being able to perform the cleaning of surfaces under vacuum or near vacuum conditions. That is possible with the substrate device 20.

One or more gas streams or one or more gas jets 44 may have an unintermittent flow 45. Instead, or in addition, one or more gas streams or one or more gas jets 44 may have an intermittent flow 46. An intermittent flow 46, or pulsed flow, may improve the particle-removal efficiency, in particular in vacuum or near vacuum conditions.

During use the substrate device 20 may be moved, or translated from a first location 47 to a second location 48 relative to the contaminated surface 42. This is schematically shown in figure 5, wherein the dashed circle indicates the substrate device 20 being at the second location 48. Such movements, or translations are usually performed with a regular to be manufactured substrate located on the electrostatic substrate clamp 21. As the substrate device 20 may be moved in a same way, the one or more nozzle holes 27 can be positioned at desired locations relative to the contaminated surface 42 for removing particles with the one or more gas jets 44 or gas streams at a plurality of locations. For example, if the substrate device 20 has one single nozzle hole, as shown in the embodiment of figure 3, the substrate device 20 may be moved around to a plurality of locations relative to the contaminated surface 42 for removing particles at said plurality of locations.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A substrate device for being held by an electrostatic substrate clamp, the substrate device having a bottom side with a bottom surface and a top side with a top surface, the bottom side being configured to face a substrate support surface of the substrate clamp in use, wherein the substrate device comprises one or more nozzle holes, the one or more nozzle holes extending from the bottom surface to the top surface.

2. Substrate device according to claim 1, wherein the substrate device is plate shaped, wherein an edge of the plate is at least partially provided with a rim projecting away from the bottom side, in particular wherein the edge of the plate is fully provided with the rim.

3. Substrate device according to claim 1 or 2, wherein the one or more nozzle holes extend above the top surface.

4. Substrate device according to any one of the preceding claims, wherein one or more nozzle holes have a central nozzle axis, wherein the central nozzle axis extends under an angle α with respect to the bottom surface, wherein the angle α is 90 degrees.

5. Substrate device according to any one of the preceding claims, wherein one or more nozzle holes have a central nozzle axis, wherein the central nozzle axis extends under an angle α with respect to the bottom surface, wherein the angle α lies between 0 and 90 degrees.

6. Substrate device according to any one of the preceding claims, wherein one or more nozzle holes are configured to be in communication with a control device for controlling a gas flow through the one or more nozzle holes.

7. Substrate device according to any one of the preceding claims, wherein the substrate device comprises a detached particle collection device.

8. Substrate device according to the preceding claim, wherein the detached particle collection device comprises an adhesive coating provided on the top surface.

9. Substrate device according to claim 7 or 8, wherein the detached particle collection device comprises an insulating layer provided on the bottom surface.

10. Combination of an electrostatic substrate clamp and a substrate device according to any one of the preceding claims, the substrate device being configured to be supported on the electrostatic substrate clamp during use.

11. Combination according to the preceding claim, wherein the electrostatic substrate clamp comprises a plurality of substrate clamp burls, the plurality of substrate clamp burls forming a substrate support surface, wherein a space is located between the substrate clamp burls and below the substrate device when supported on the substrate support surface, wherein during use the one or more nozzle holes are in fluid communication with the space, and wherein the space is configured to be in fluid communication with a gas supply.

12. Lithographic apparatus comprising a combination according to claim 10 or 11.

13. Method for cleaning a contaminated surface of a stage compartment of a lithographic apparatus, the method comprising:
a) providing and clamping a substrate device according to any one of claims 1-9 onto a substrate support surface of an electrostatic substrate clamp arranged in the stage compartment,
b) providing a gas through the one or more nozzle holes to generate one or more gas streams or one or more gas jets flowing in an upward direction from the bottom side to the top side,
c) directing the gas stream or gas jet to the contaminated surface in order to detach particles adhering to the contaminated surface.

14. Method according to the preceding claim, wherein the steps a), b) and c) are performed under vacuum conditions or under near vacuum conditions.

15. Method according to any one of the preceding method claims, comprising collecting the detached particles by a vacuum pump and/or by a detached particle collecting device of the substrate device.

16. Method according to any one of the preceding method claims, wherein one or more gas streams or one or more gas jets have an unintermittent flow, and/or wherein one or more gas streams or one or more gas jets have an intermittent flow.

17. Method according to any one of the preceding method claims, comprising translating the substrate device from a first location to a second location relative to the contaminated surface, wherein steps b) and c) are performed at the first location and the second location.

18. Method according to any one of the preceding method claims, wherein the stage compartment is a wafer stage compartment.

19. Method according to any one of the preceding method claims, wherein the gas is hydrogen.

20. Method according to any one of the preceding method claim, wherein the gas is nitrogen or extreme clean dry air.
